# EUROPÄISCHE PATENTSCHRIFT

(11) **EP 0 744 832 B1**
(45) Veröffentlichungstag und Bekanntmachung des Hinweises auf die Patenterteilung: **28.11.2001**
(21) Anmeldenummer: 96108000.9
(22) Anmeldetag: 20.05.1996
(51) Int. Cl.: H03H 11/18

(54) **Schaltungsanordnung zum Erzeugen eines gegenüber einem Eingangssignal orthogonalen Ausgangssignal sowie Verwendungen dieser Schaltungsanordnung**
Circuit for generating an output signal orthogonal to an input signal and applications of said circuit
Circuit pour la génération d'un signal de sortie orthogonal à un signal d'entrée et utilisation de ce circuit

(30) Priorität: 24.05.1995 DE 19519156
(43) Veröffentlichungstag der Anmeldung: 27.11.1996
(73) Patentinhaber: Infineon Technologies AG, 81669 München (DE)
(72) Erfinder: Irvine, Robert-Grant, 80339 München (DE); Veit, Werner, Dipl.-Ing., 82008 Unterhaching (DE); Fenk, Josef, Dipl.-Ing., 85386 Eching (DE)
(74) Vertreter: Fischer, Volker, Dipl.-Ing.

(56) Entgegenhaltungen:
- EP-A- 0 452 776
- EP-A- 0 455 156
- ELECTRONICS LETTERS, Bd. 20, Nr. 10, Mai 1984, STEVENAGE GB, Seiten 431-432, XP002011724 E. W. TAY ET AL.: "Unity-Gain Frequency-Independent Quadrature Phase Shifter"
- PATENT ABSTRACTS OF JAPAN vol. 002, no. 027 (E-016), 21.Februar 1978 & JP-A-52 147943 (MITSUBISHI ELECTRIC CORP), 8.Dezember 1977,
- PATENT ABSTRACTS OF JAPAN vol. 018, no. 120 (E-1516), 25.Februar 1994 & JP-A-05 315888 (NEC IC MICROCOMPUT SYST LTD), 26.November 1993,

## Beschreibung

Die Erfindung betrifft eine Schaltungsanordnung zur Erzeugung eines gegenüber einem Eingangssignal orthogonalen Ausgangssignals sowie Verwendungen dieser Schaltungsanordnung.

Derartige Schaltungsanordnungen werden auch 90°-Phasenschieber genannt und sind in zahlreichen Ausgestaltungen allgemein bekannt. Problematisch ist dabei, daß wenig Schaltungsaufwand erfordernde Anordnungen meist nur bei einer Frequenz innerhalb eines engen Bereiches optimal arbeiten, während Anordnungen, die größere Frequenzschwankungen zulassen, meist einen hohen Schaltungsaufwand erfordern.

In der Literaturstelle Electronic Letters, Band 20, Nr. 10, Mai 1984, London, Great Britain, Seiten 431 bis 432, E.W. Tay et al.: "Unity-Gain Frequency-Independent Quadrature Phase Shifter" ist eine Schaltungsanordnung zur Erzeugung eines gegenüber einem Eingangssignal um 90° verschobenen Ausgangssignals gezeigt. Das Eingangssignal wird einem Allpaß zugeführt, der eine steuerbare Phasenverschiebung erzeugt. Das Ausgangssignal des Allpasses wird mit dem Eingangssignal multipliziert, über ein Tiefpaßfilter geführt, integriert und zur Steuerung der Phasenverschiebung in den Allpaß rückgekoppelt.

In der EP-A-0 452 776 ist eine Verzögerungsschaltung mit einstellbarer Verzögerungszeit gezeigt. Die Ausgangsstufe der Schaltung enthält differentiell angesteuerte Emitterfolgertransistoren mit emitterseitigen Stromquellen. Zwischen die Emitter ist ein Kondensator geschaltet. Die Stromquellen werden vom selben Signal angesteuert und sind als Konstantstromquellen ausgebildet.

Aufgabe der Erfindung ist es, eine Schaltungsanordnung der eingangs genannten Art anzugeben, die bei geringerem Aufwand und bei Frequenzschwankungen über einen weiten Bereich eine konstante 90°-Phasenverschiebung erzeugt.

Die Aufgabe wird durch eine Schaltungsanordnung gemäß Patentanspruch 1 gelöst. Bevorzugte Verwendungen der erfindungsgemäßen Schaltungsanordnung sind in weiteren unabhängigen Ansprüchen gekennzeichnet.

Die Erfindung wird nachfolgend anhand der in den Figuren der Zeichnung dargestellten Ausführungs- und Anwendungsbeispiele näher erläutert. Es zeigt:
Figur 1 eine grundsätzliche Ausführungsform einer erfindungsgemäßen Schaltungsanordnung sowie deren Anwendung und
Figur 2 eine bevorzugte Ausführungsform einer steuerbaren Verzögerungseinrichtung bei einer erfindungsgemäßen Schaltungsanordnung.

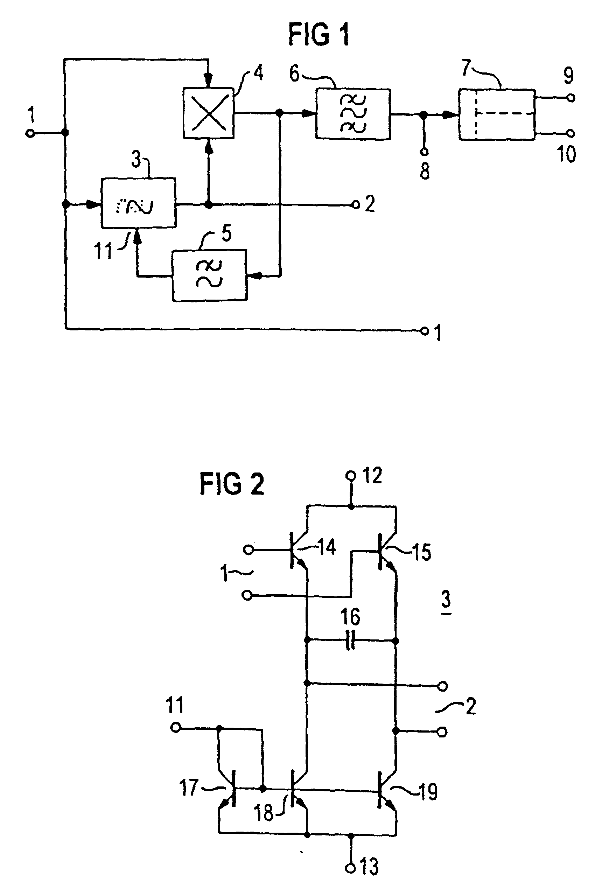

Gemäß Figur 1 besteht eine erfindungsgemäße Schaltungsanordnung aus einer Verzögerungseinrichtung 3, an deren Eingang ein Eingangssignal 1 angelegt ist und an deren Ausgang ein Ausgangssignal 2 bereitsteht. Die Verzögerungszeit der Verzögerungseinrichtung 3 ist mittels eines an dessen Eingang 11 anliegenden Steuersignals veränderbar. Das Steuersignal wird aus dem Gleichanteil des Produktes des Eingangssignals 1 und des Ausgangssignals 2 gebildet. Dazu werden das Eingangssignal 1 und das Ausgangssignal 2 mittels eines Multiplizierers 4 miteinander multipliziert, das daraus sich ergebende Produkt einer Tiefpaßfilterung mittels eines Tiefpasses 5 unterzogen und schließlich dem Steuereingang 11 der Verzögerungseinrichtung 3 zugeführt.

Hat beispielsweise das Eingangssignal 1 den Verlauf von sin x, dann ergibt sich im Idealfall für das Ausgangssignal 2 ein Verlauf von cos x. Durch Multiplikation des Eingangssignals 1 mit dem Ausgangssignal 2 ergibt sich ein Verlauf von sin 2x. Das Ausgangssignal 2 hat also nur Wechselanteile. Im nichtidealen Fall wird hingegen ein Signal erzeugt, das neben einem Wechselanteil auch einen Gleichanteil enthält. Durch die nachfolgende Tiefpaßfilterung wird ein eventuell auftretender Gleichanteil extrahiert. Ist nun die Verzögerungszeit der Verzögerungseinrichtung 3 nicht so eingestellt, daß sich eine Phasenverschiebung von 90° ergibt, dann ist beim Ausgangssignal 2 der Gleichanteil ungleich Null. Die Verzögerungseinrichtung 3, die Multipliziereinrichtung 4 und der Tiefpaß 5 bilden nun einen Regelkreis, der im eingeregelten Zustand unabhängig von der Frequenz des Eingangssignals 1 eine Phasenverschiebung von 90° einstellt, indem er den Gleichanteil im Ausgangssignal 2 auf Null regelt und damit die Verzögerungszeit der Verzögerungseinrichtung 3 an die jeweilige Frequenz des Eingangssignals 1 anpaßt.

Schaltungsanordnungen zur Erzeugung eines gegenüber einem Eingangssignal orthogonalen Ausgangssignals werden beispielsweise bei Schaltungsanordnungen zur Verdoppelung der Frequenz des Eingangssignals 1 benötigt. Dazu wird üblicherweise einem Multiplizierer das Eingangssignal 1 und ein dazu orthogonales Signal, beispielsweise das Ausgangssignal 2 zugeführt. Da jedoch bereits durch den Multiplizierer 4 Eingangssignal 1 und Ausgangssignal 2 miteinander multipliziert werden, kann auf einen weiteren Multiplizierer verzichtet werden und stattdessen das am Ausgang des Multiplizierers 4 bereitstehende Signal abgenommen werden. Am Ausgang des Multiplizierers 4 tritt demnach bereits ein Ausgangssignal auf, das die doppelte Frequenz des Eingangssignals 1 hat.

Die Erfindung ausgestaltend ist dem Multiplizierer 4 ein Bandpaß 6 nachgeschaltet, um eventuell auftretende, unerwünschte spektrale Komponenten, die beispielsweise durch Ungenauigkeiten beim Multiplizierer hervorgerufen werden können, zu dämpfen. Das Ausgangssignal 8 des Bandpasses 6 hat damit die doppelte Frequenz des Eingangssignals 1, wobei praktisch keine störenden Spektralanteile enthalten sind.

Die Schaltungsanordnung zur Erzeugung eines Signals mit der doppelten Frequenz des Eingangssignals 1 kann bei einer weiteren Anwendung auch derart eingesetzt werden, daß das Ausgangssignal 8 einem Toggle-Flip-Flop 7 zugeführt wird, an dessen Master- und Slaveausgang jeweils ein Ausgangssignal 9 bzw. 10 bereitsteht. Die Ausgangssignale 9 und 10 sind dabei einander gegenüber orthogonal und haben jeweils die halbe Frequenz des Ausgangssignals 8. Somit werden insgesamt bei dieser Schaltungsanordnung aus dem Eingangssignal 1 zwei zueinander orthogonale Ausgangssignale 9, 10 gleicher Frequenz erzeugt, deren Tastverhältnis jeweils exakt 1:1 ist, wenn die Phasenverschiebung zwischen Eingangssignal 1 und Ausgangssignal 2 90° beträgt.

Toggle-Flip-Flops im allgemeinen sind beispielsweise aus U.Tietze, Ch.Schenk, Electronic Circuits-Design and Applications, Springer-Verlag, Berlin, Heidelberg 1991, Seiten 213 bis 215 bekannt. Toggle-Flip-Flops mit Master- und Slaveausgang im speziellen bestehen dabei aus zwei einzelnen Toggle-Flip-Flops, wobei die Dateneingänge beider Flip-Flops mit dem Ausgang des jeweils anderen Flip-Flops verbunden sind. Ein Signal gegebener Frequenz, beispielsweise das Signal 8, wird dabei an ein Flip-Flop invertiert und an das andere nichtinvertiert angelegt. An den Ausgängen der beiden Flip-Flops stehen schließlich zwei zueinander orthogonale Signale mit jeweils halber Frequenz des Signals 8 zur Verfügung.

Bevorzugt findet bei der Schaltungsanordnung nach Figur 1 eine steuerbare Verzögerungseinrichtung 3 gemäß Figur 2 Verwendung. Die als Ausführungsbeispiel gezeigte Verzögerungseinrichtung 3 enthält eine Kapazität 16, an deren Anschlüssen das Ausgangssignal 2 in differenzieller Form abgreifbar ist. Die Anschlüsse der Kapazität 16 sind zudem jeweils über die Laststrecken zweier Transistoren 14 und 15 mit einem Versorgungspotential 12 und über die Laststrecke zweier weiterer Transistoren 18 und 19 mit einem Versorgungspotential 13 verbunden.

Die Basen der beiden Transistoren 14 und 15 werden durch das Eingangssignal 1, das in differenzieller Form vorliegt, gesteuert. Die Basen der beiden Transistoren 18 und 19 sind miteinander und mit dem Eingang 11 verbunden. Zudem ist ein durch Verbinden von Basis- und Kollektor zu einer Diode verschalteter Transistor 17 zwischen die miteinander verschalteten Basen der Transistoren 18 und 19 einerseits und das Versorgungspotential 13 andererseits geschaltet. Die Transistoren 17, 18 und 19 bilden eine Strombank, d.h. einen Stromspiegel mit einem Eingangs- und zwei Ausgangszweigen, wobei die beiden Ausgangszweige zwei gleich große Ströme liefern, die in einem bestimmten Verhältnis zu dem in den Eingang 11 eingespeisten Strom stehen. Anstelle einer Strombank können aber in gleicher Weise auch separate, identische Stromquellen vorgesehen werden, die durch einen entsprechenden Strom oder eine entsprechende Spannung am Steuereingang 11 angesteuert werden.

Für den Fall, daß der vorausgehende Tiefpaß 5 eine Spannung anstelle eines Stromes an seinem Ausgang bereitstellt, ist demzufolge dann ein Spannungs-Strom-Umsetzer zwischen Tiefpaß 5 und Verzögerungseinheit 3 zu schalten.

Beim vorliegenden Ausführungsbeispiel sind sämtliche Transistoren 14, 15, 17, 18, 19 Bipolartransistoren vom npn-Typ. Dabei ist das Versorgungspotential 12 positiv und das Versorgungspotential 13 negativ. Weiterhin werden demzufolge in Weiterbildung der Erfindung die Transistoren 14 und 15 in Verbindung mit den durch die Transistoren 18, 19 gebildeten Stromquellen als Emitterfolger betrieben. Diese Betriebsweise hat zum einen den Vorteil, daß eine höhere Grenzfrequenz der Verzögerungseinrichtung erreicht wird, da die beiden Transistoren 14 und 15 nicht in Sättigung gehen können. Zum anderen ermöglicht der Einsatz von Emitterfolgern, daß auch kontinuierliche Analogsignale als zu verzögernde Signale angelegt werden können, da es keinen Übernahmebereich zwischen den beiden Transistoren 14 und 15 gibt.

Im dynamischen Betrieb der Verzögerungseinrichtung bestimmen die beiden untereinander gleichen Emitterströme der Transistoren 14 und 15 die Geschwindigkeit, mit der die Kapazität 16 umgeladen wird und bestimmen demzufolge die Verzögerungszeit zwischen den Nulldurchgängen des Eingangssignals 1 und den Nulldurchgängen des Ausgangssignals 2.

## Patentansprüche

1. Schaltungsanordnung zur Erzeugung eines gegenüber einem Eingangssignal orthogonalen Ausgangssignals mit einer Verzögerungseinrichtung (3), an deren Eingang das Eingangssignal (1) angelegt ist, an deren Ausgang das Ausgangssignal (2) bereitsteht und die einen Steuereingang (11) zur Steuerung der Verzögerungszeit aufweist, mit einer Multipliziereinrichtung (4), deren Eingänge mit Ein- und Ausgang der Verzögerungseinrichtung gekoppelt sind und die einen Ausgang aufweist, und mit einer Einrichtung zur Tiefpaßfilterung (5), die zwischen den Ausgang der Multipliziereinrichtung (4) und den Steuereingang (11) der Verzögerungseinrichtung (3) geschaltet ist,
**dadurch gekennzeichnet, daß** die Verzögerungseinrichtung (3) eine Kapazität umfaßt, an der das Ausgangssignal (2) abgreifbar ist, zwei durch das Eingangssignal (1) invers zueinander gesteuerte Transistoren (14, 15), deren Laststrecken zwischen jeweils einen Anschluß der Kapazität (16) und ein erstes Versorgungspotential (12) geschaltet sind und zwei durch ein am Steuereingang (11) anliegendes Signal gesteuerte, gleich große Ströme liefernde Stromquellen (18, 19), die zwischen jeweils einen Anschluß der Kapazität (16) und ein zweites Versorgungspotential (13) geschaltet sind.

2. Verwendung der Schaltungsanordnung nach Anspruch 1 bei einer Schaltungsanordnung zur Erzeugung eines Signals mit einer gegenüber dem Eingangssignal doppelten Frequenz,
**dadurch gekennzeichnet, daß** der Multipliziereinrichtung (4) ein Bandpaßfilter (6) nachgeschaltet ist, an dessen Ausgang das Signal (8) mit doppelter Frequenz bereit gestellt wird.

3. Verwendung der Schaltungsanordnung nach Anspruch 1 bei einer Schaltungsanordnung zur Erzeugung zweier zueinander orthogonaler Ausgangssignale,
**dadurch gekennzeichnet, daß** der Multipliziereinrichtung (4) ein Toggle-Flip-Flop (7) nachgeschaltet ist, an dessen Ausgängen die beiden zueinander orthogonalen Ausgangssignale (9, 10) bereitstehen.

4. Verwendung nach Anspruch 3,
**dadurch gekennzeichnet, daß** der Multipliziereinrichtung (4) unmittelbar eine Einrichtung zur Bandpaßfilterung (6) nachgeschaltet ist.

## Claims

1. Circuit arrangement for generating an output signal which is orthogonal to an input signal, comprising a delay device (3), to the input of which the input signal (1) is applied, at the output of which the output signal (2) is available and which has a control input (11) for controlling the delay time, comprising a multiplier device (4), the inputs of which are coupled to input and output of the delay device and which has an output, and comprising a device for low-pass filtering (5) which is connected between the output of the multiplier device (4) and the control input (11) of the delay device (3), **characterized in that** the delay device (3) comprises a capacitor across which the output signal (2) can be picked up, two transistors (14, 15) which are controlled inversely with respect to one another by the input signal (1) and the load circuits of which are connected between in each case one terminal of the capacitor (16) and a first supply potential (12) and two current sources (18, 19) which supply equally large currents, are controlled by a signal present at the control input (11) and are connected between in each case one terminal of the capacitor (16) and a second supply potential (13).

2. Use of the circuit arrangement according to Claim 1 in a circuit arrangement for generating a signal having twice the frequency compared with the input signal, **characterized in that** the multiplier device (4) is followed by a band-pass filter (6) at the output of which the signal (8) is provided at twice the frequency.

3. Use of the circuit arrangement according to Claim 1 in a circuit arrangement for generating two mutually orthogonal output signals, **characterized in that** the multiplier device (4) is followed by a toggle flip-flop (7), at the outputs of which the two mutually orthogonal output signals (9, 10) are available.

4. Use according to Claim 3, **characterized in that** the multiplier device (4) is followed directly by a device for band-pass filtering (6).

## Revendications

1. Circuit pour la production d'un signal de sortie orthogonal à un signal d'entrée, comprenant un dispositif de retardement (3) à l'entrée duquel le signal d'entrée (1) est appliqué, à la sortie duquel le signal de sortie (2) est disponible et qui comporte une entrée de commande (11) pour la commande du retard, un dispositif de multiplication (4) dont les entrées sont reliées à l'entrée et à la sortie du dispositif de retardement et qui comporte une sortie et comprenant un dispositif pour le filtrage passe-bas (5) qui est branché entre la sortie du dispositif de multiplication (4) et l'entrée de commande (11) du dispositif de retardement (3),
**caractérisé par le fait que** le dispositif de retardement (3) comprend une capacité à laquelle le signal de sortie (2) peut être prélevé, deux transistors (14, 15) qui sont commandés à l'inverse l'un de l'autre par un signal d'entrée (1) et dont les sections de charge sont branchées entre respectivement une borne de la capacité (16) et un premier potentiel d'alimentation (12) et deux transistors (18, 19) qui sont commandés par un signal présent à l'entrée de commande (11), qui fournissent des courants de même grandeur et qui sont branchés entre respectivement une borne de la capacité (16) et un deuxième potentiel d'alimentation (13).

2. Utilisation du circuit selon la revendication 1 pour un circuit destiné à la production d'un signal ayant une fréquence double de celle du signal d'entrée,
**caractérisée par le fait qu'**il est branché du côté aval du dispositif de multiplication (4) un filtre passe-bande (6) à la sortie duquel le signal (8) ayant une fréquence double est disponible.

3. Utilisation du circuit selon la revendication 1 pour un circuit destiné à la production de deux signaux de sortie orthogonaux l'un à l'autre,
**caractérisée par le fait qu'**il est branché du côté aval du dispositif de multiplication (4) une bascule bistable dite toggle (7) aux sorties de laquelle les deux signaux de sortie (9, 10) orthogonaux l'un à l'autre sont disponibles.

4. Utilisation selon la revendication 3,
**caractérisée par le fait qu'**il est branché directement du côté aval du circuit de multiplication (4) un dispositif pour le filtrage passe-bande (6).
